Europäisches Patentamt

(19) European Patent Office

Office européen des brevets

(11) Publication number : **0 448 545 A1**

(12) # EUROPEAN PATENT APPLICATION

(21) Application number : **91870049.3**

(22) Date of filing : **20.03.91**

(51) Int. Cl.⁵ : **H05K 5/00, H02G 3/08**

(30) Priority : **21.03.90 BE 9000322**

(43) Date of publication of application :
**25.09.91 Bulletin 91/39**

(84) Designated Contracting States :
**BE DE DK ES IT NL**

(71) Applicant : **VYNCKIER Naamloze Vennootschap**
**Nieuwe Vaart 51**
**B-9000 Gent (BE)**

(72) Inventor : **De Rouck, Etienne**
**Hundelgemsesteenweg 166, bus 45**
**B-9220 Merelbeke (BE)**

(74) Representative : **Pieraerts, Jacques et al**
**Bureau Gevers S.A. rue de Livourne 7 bte 1**
**B-1050 Bruxelles (BE)**

(54) **Cases, especially for electrical material provided for being coupled.**

(57)   Cases especially for electrical materials provided for being coupled and consisting of a frame formed by a bottom, with respect to this bottom upright profiles and lengthwise and cross-wise ribs which are parallel to this bottom and which are further provided with a cover or a little door and with panels, wherein at least a part of said profiles (3) are provided with lengthwise slots (6) of such a cross-section that when joining two cases provided for being coupled side-by-side, a mutual cut-out (8) is realized wherein a coupling piece (7) can be pushed.

EP 0 448 545 A1

Fig.2.

This invention relates to cases especially for electrical materials provided for being coupled and consisting of a frame formed by a bottom, with respect to this bottom upright profiles and lengthwise and crosswise ribs which are parallel to this bottom and which are further provided with a cover or a little door and with panels.

Such cases for storing electrical material which are open at the front, which can be closed by a cover or a door and which can moreover be mutually coupled to realize a larger volume are known from German Patent DE-U-7205256.

Cases according to this German patent protect the built-in apparatus more or less against penetration of foreign solid objects and against penetration of liquid, i.e. they provide a certain protection degree.

The sealing degree of these cases is limited and experience has shown that increasing the sealing degree requires the use of elastically deformable compressible seals continuously over the four sides of a side wall against which the component (either a side panel or another case) is pushed. According to DE-U-7205256, a seal can be provided between the bottom and the side wall and between the cover and the side wall but no seal can be provided in the direction perpendicular to the bottom since the side wall has to be pushed in upright profiles.

An object of the invention is to provide a new and original concept of a case provided for being coupled whereby rectangular cases can be mutually coupled as well with their short as with their long side and an absolute water and dust tight coupling can be realized.

In order to make this possible according to the invention, at least a part of said profiles are provided with lengthwise slots of such a cross-section that when joining two cases provided for being coupled side-by-side, a mutual cut-out is realized wherein a coupling piece can be pushed.

Still according to the invention, said profiles are corner profiles.

In the same spirit, said profiles for coupling two ribs are situated at an arbitrary distance between two corners of the case.

According to one of the many possible embodiments, said slots have a L-shaped cross-section having one leg directed to the outside of the profile and said coupling piece has then a U-shaped cross-section.

A particularity of the invention consists in that said upright profiles which are not corner profiles are situated at such a distance from the corners of the cases that at least two smaller cases can be coupled with one side along a side of a bigger case.

Other details and advantages of the invention will become apparent from the following description of cases, amongst others for electrical apparatuses, provided for being coupled according to the invention.

This description is only given by way of example and does not limit the invention. The reference numerals relate to the annexed drawings.

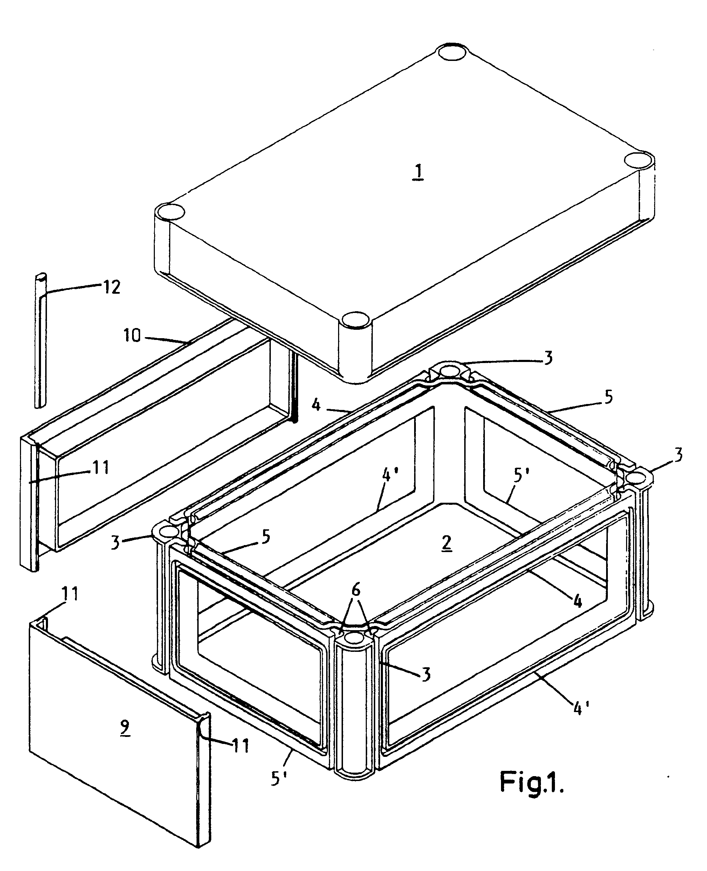

Figure 1 is a perspective exploded view of a case according to the invention.

Figure 2 shows also a perspective view of two cases to be coupled along their longitudinal side and one coupling piece.

Figure 3 shows a top plan view of a modular embodiment of three cases provided for being coupled according to the invention.

Figure 4 shows on a larger scale a detail of the cases provided for being coupled according to the invention.

The cases provided for being coupled shown in these figures, have the general appearance of a parallelepiped. The fact that the cases shown by the figures are rectangular is of course of secondary importance. Cases having a different appearance do clearly fall within the scope of this patent application.

The cases according to the figures provided for being coupled consist of a removable cover 1, a bottom 2 and four corner profiles 3 wherein lengthwise ribs 4 and 4' extend in longitudinal direction and between said corner profiles. The latter ribs, i.e. ribs 4', are part of the bottom 2.

Along the two short sides are provided cross-wise ribs 5 and 5'. These latter ribs are part of the bottom 2 too. The figures which are discussed here belong clearly to one of the possible embodiments. Indeed, all of the sides do not have to be open. This structure offers, however, a large flexibility since an object of the invention is precisely to realize an integral water and dust tight seal of this side by structures which are to be described further.

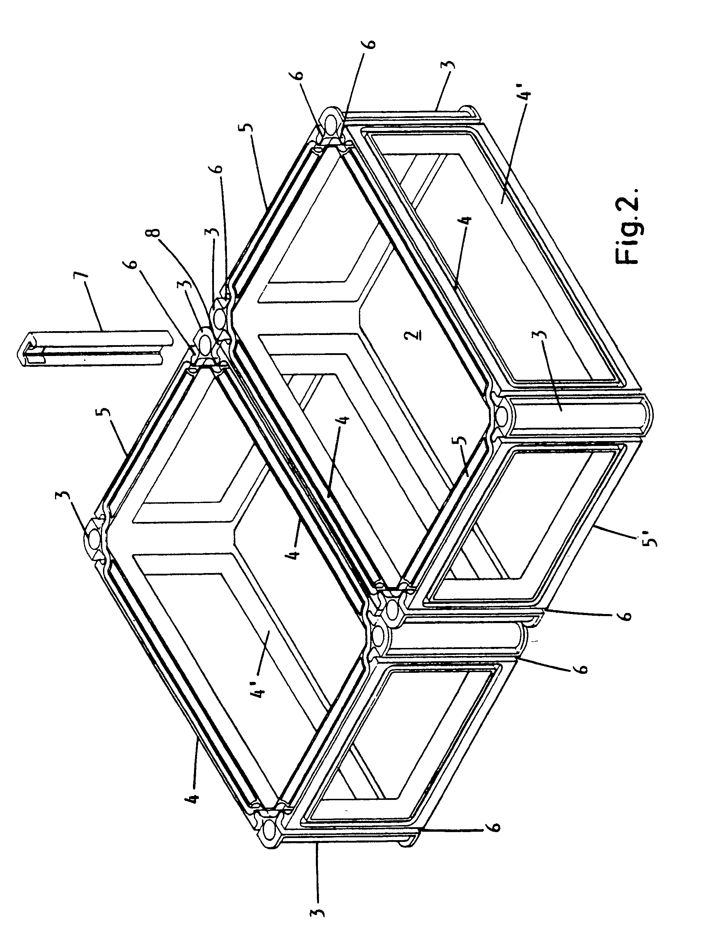

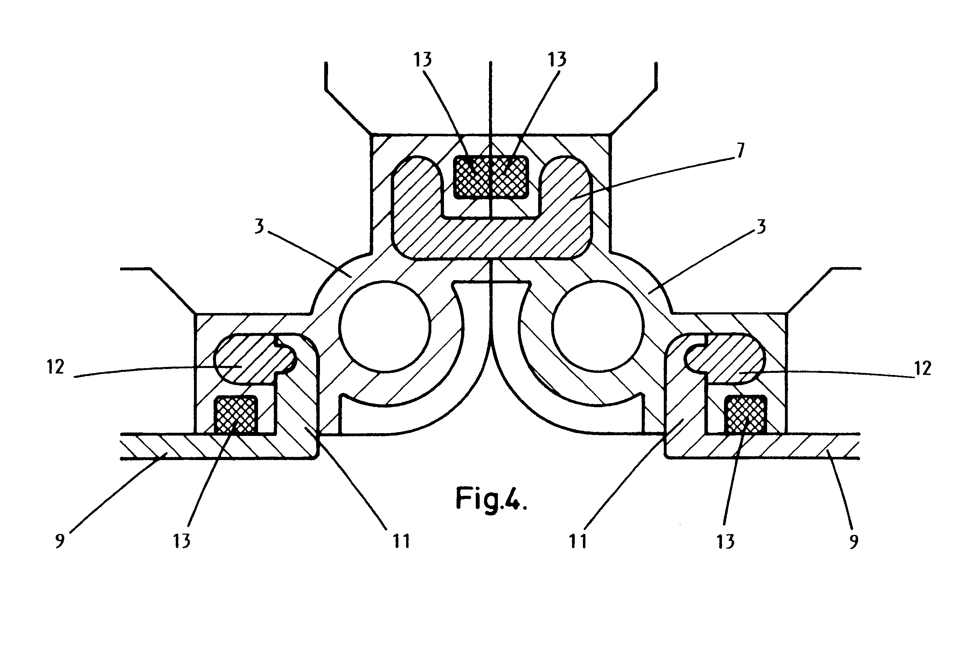

In order to couple two sides to one another, as shown in figures 2, 3 and 4, all corner profiles are provided with two slots 6 having a L-shaped cross-section. These slots may be continuous or may be of a limited length. When two cases provided for being coupled are placed side-by-side against each other, either with their lengthwise or with their cross-wise side and are to be coupled mutually, two L-shaped slots provide together a U-shaped profile as appears very clearly from figures 2-4. In order to couple two cases, only coupling pieces 7 have to be pushed now in these U-shaped cut-outs realized when joining two L-shaped slots 6. For clarifying the invention idea, reference 8 is given in figure 2 to the two U-shaped cut-outs realized when joining the two L-shaped slots 6.

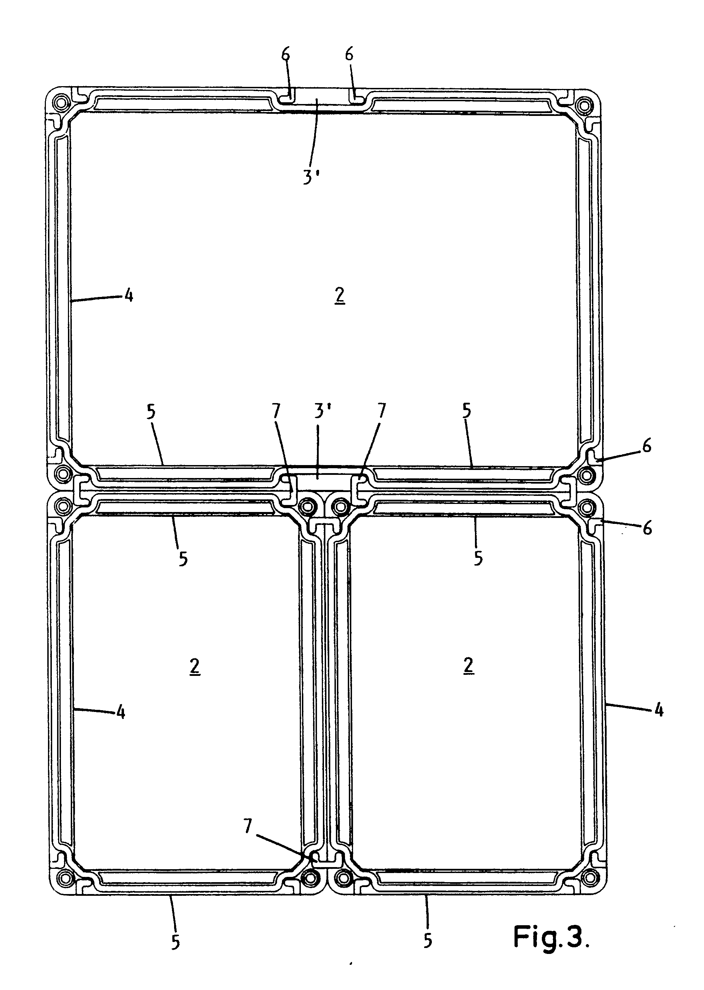

Said L-shaped slots 6 are moreover used for assembling little panels 9 (cross-panels) and 10 (longitudinal panels). Profiles 3' are shown in figure 3. They are provided with the same L-shaped slots.

The little panels 9 and 10 are provided with hook-shaped projections 11 extending over the total height or over a part of the height of the panels. When the little panels 9 or 10 are pressed between the respective corner profiles 3 into the outwards directed leg of a L-shaped slot 6, then the hook-shaped projections 11 can extend so far into this leg of the slot 6 that an elongated lock peg 12 can be pushed in the other leg of the L-shaped slot. The cross-section of a L-shaped lock peg 12 is complementary to the cross-section of a hook-shaped projection 11 and fills therefore completely the space remaining in one of the legs of the L-shaped slot after the hook-shaped projections 11 of the little panels 9 or 10 are pushed in the other leg of the L-shaped slot. When reference is mainly made here to L-shaped slots, it has to be underlined very clearly that the same function can be fulfilled by a T -, an I-, a Y-, a V- section or the like, the coupling piece as well as the little lock peg being then adapted to the cross-section realized when joining two cases with a slot corresponding to said cross-sections.

The hereabove description of the invention shows therefore clearly that cases provided for being coupled according to the invention are suitable for combining several units in order to create spaces which are sealed integrally dust and water tight.

For coupling the cases as well as for fixing the little panels, use is made of the same, for example L-shaped slots 6 present in the profiles 3. In combination with the L-shaped slot of an adjoining case, a U-shaped cut-out is realized wherein a coupling piece 7 can be pushed. The little panels are provided with hook-shaped projections 11 which extend so far into the L-shaped slot that a lock peg 12 can be pushed in the remaining space of the L-shaped slot. By pushing in the coupling pieces 7 and the lock pegs 12, respectively, not only a good coupling is realized between two cases and, respectively, a little panel and the case, but due to the thereby realized clamping, compressible seals 13, fixed in continuous grooves 13′, provide for the desired integral water and dust tight seal.

It is clear that the invention is not limited to the hereabove described embodiment and that it can be modified in many ways without departing from the spirit of the patent application.

## Claims

1. Cases especially for electrical materials provided for being coupled and consisting of a frame formed by a bottom, with respect to this bottom upright profiles and lengthwise and cross-wise ribs which are parallel to this bottom and which are further provided with a cover or a little door and with panels, characterized in that at least a part of said profiles (3) are provided with lengthwise slots (6) of such a cross-section that when joining two cases provided for being coupled side-by-side, a mutual cut-out (8) is realized wherein a coupling piece (7) can be pushed.

2. Cases provided for being coupled according to claim 1, characterized in that said profiles (3) are corner profiles.

3. Cases provided for being coupled according to claim 1, characterized in that said profiles (3) for coupling two cases are situated at an arbitrary distance between two corners of the case.

4. Cases provided for being coupled according to anyone of the claims 1-3, characterized in that said slots (6) run at least over a portion of the length of said profiles (3).

5. Cases provided for being coupled according to anyone of the claims 1-4, characterized in that said slots (6) have a L-shaped cross-section having one leg directed towards the outside of the profile and in that said coupling piece (7) then has a U-shaped cross-section.

6. Cases provided for being coupled according to anyone of the claims 1-4, characterized in that said slots (6) have a substantially Y-shaped cross-section and said coupling piece a double Y-shaped cross-section.

7. Cases provided for being coupled according to anyone of the claims 1-4, characterized in that said slots (6) have a substantially V-shaped cross-section so that two opposite slots (6) in two cases to be coupled form an X and said coupling piece has an X-cross-section.

8. Cases provided for being coupled according to anyone of the claims 1-4, characterized in that said slots (6) have a T-shaped cross-section and said coupling piece has then a double T-shaped cross-section.

9. Cases provided for being coupled according to anyone of the claims 1-8, characterized in that at least one of said little panels (9, 10) is removable and provided to this end, along the two sides which are in the use position parallel to said upright profiles, with projections (11) having a cross-section which is adapted to the slots according to anyone of the claims 1-8 and which cooperates with a lock peg (12) having a cross-section adapted to the cross-section of said slots according to anyone of the claims 1-8.

10. Cases provided for being coupled according to anyone of the claims 3-9, characterized in that said upright profiles (3) which are not corner profiles are situated at such a distance from the corners of the cases that at least two smaller cases can be coupled with one side along a side of a bigger case.

11. Cases provided for being coupled according to anyone of the claims 1-10, characterized in that compressible seals (13) are provided in corresponding continuous grooves (13') along said upright profiles, lengthwise and cross-wise upright profiles.

Fig.1.

Fig.2.

Fig.3.

Fig.4.

**European Patent Office**

# EUROPEAN SEARCH REPORT

Application Number

EP 91 87 0049

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | FR-A-2417957 (DIEFENTHAL)<br>* page 3, lines 6 - 34; claims 1, 6, 8; figures 1, 3, 4-7, 9 * | 1-4, 7, 8 | H05K5/00<br>H02G3/08 |
| D,X | DE-U-7205256 (ELEK)<br>* page 5, last paragraph - page 9, last paragraph; figures 1-13 * | 1, 3, 10 | |
| D,A | | 9 | |

|  |
|---|
| **TECHNICAL FIELDS SEARCHED (Int. Cl.5)** |
| H05K<br>H02G<br>H02B |

The present search report has been drawn up for all claims

| Place of search | Date of completion of the search | Examiner |
|---|---|---|
| THE HAGUE | 21 JUNE 1991 | RIEUTORT A.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)